Europäisches Patentamt

European Patent Office

Office européen des brevets

(11) Publication number:

**0 108 603**
**B1**

# EUROPEAN PATENT SPECIFICATION

(45) Date of publication of patent specification: **29.06.88**

(51) Int. Cl.⁴: **H 03 K 17/14**

(21) Application number: **83306657.4**

(22) Date of filing: **02.11.83**

(54) **Field effect transistor gate circuit for switching analog signals.**

(30) Priority: **02.11.82 JP 192952/82**

(43) Date of publication of application:
**16.05.84 Bulletin 84/20**

(45) Publication of the grant of the patent:
**29.06.88 Bulletin 88/26**

(84) Designated Contracting States:
**DE FR GB**

(56) References cited:
**FR-A-2 509 931**
**US-A-3 902 078**

**IEEE JOURNAL OF SOLID-STATE CIRCUITS,
vol. SC-14, no. 6, December 1979, pages
944-952, IEEE; A.R.HAMADE: "Temperature
compensated quad analog switch"**

(73) Proprietor: **FUJITSU LIMITED**
**1015, Kamikodanaka Nakahara-ku
Kawasaki-shi Kanagawa 211 (JP)**

(72) Inventor: **Nishimori, Eiji Fujitsu Ltd. Patent
Dept.
1015 Kamikodanaka Nakahara-ku
Kawasaki-shi Kanagawa 211 (JP)**
Inventor: **Tsuchiya, Chikara Fujitsu Ltd. Patent
Dept.
1015 Kamikodanaka Nakahara-ku
Kawasaki-shi Kanagawa 211 (JP)**
Inventor: **Sano, Yoshiaki Fujitsu Ltd. Patent
Dept.
1015 Kamikodanaka Nakahara-ku
Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

The present invention relates to a field effect transistor gate circuit for switching analog signals. More particularly, it is concerned with a gate circuit for switching analog signals on and off by means of field effect transistors.

Switching of analog signals has generally been performed by relays, but recently it has become important to handle analog signals by means of semiconductor devices and this means that signal distortion has become an important factor. That is, a signal passed through a relay suffers no distortion, but a signal passed through semiconductor devices does.

One approach used in an attempt to avoid distortion problems with analog signals handled by semiconductor devices is to handle only small signals. This approach has been tried because even if the semiconductor device transfer characteristic is not linear a small signal amplitude is not so distorted as a larger signal amplitude. However, the need to employ solid state switching devices is increasing, because of their small size, quick response, small operational power consumption, high reliability, economy and so on. Moreover, such devices are required which can handle larger amplitude signals.

For switching signals, field effect transistors (FET) are widely used. However, in circuits which switch analog signals by turning FET's on and off, variation in the internal resistance of an FET when it is in an on state (on-resistance), according to the voltage between source and drain (source-drain voltage) and signal polarity causes distortion of signals passing through the FET.

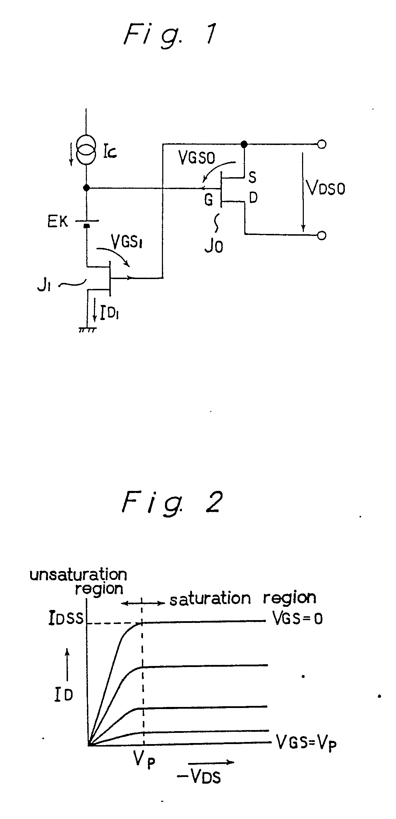

Figure 1 is a schematic circuit diagram of a previous switching circuit for analog signals. In the Figure, $J_0$ is a p-channel type FET for signal switching, $I_C$ is a constant current source supplying current to gate G of the FET $J_0$ and so on. $E_K$ is a control voltage source varying the conductivity of FET $J_0$ and shifting the state of $J_0$ on and off.

The fundamental switching process in the circuit of Figure 1 is performed by switching FET $J_0$ on and off. Namely, when the control voltage provided by source $E_K$ is high, the channel between source S and the drain D of FET $J_0$ is pinched off by a depletion layer which expands (extends) as a result of the high gate voltage applied to $J_0$, and the switch is off (gate is closed). On the other hand, when the control voltage provided by source $E_K$ is low, the depletion layer contracts (narrows), and the switch is on (gate is opened). So, the state of the switch (the on-off state of the gate) is determined by the state, low or high, of the control voltage.

FET $J_1$ in Figure 1 detects the voltage of the source S of FET $J_0$ and provides feedback to the gate G of FET $J_0$ in order to maintain the voltage between gate G and source S of $J_0$ ($V_{GS0}$) constant, independent to source voltage.

FET drain current has saturation characteristics as shown in the graph of Figure 2. The graph shows the drain current $I_D$ versus source-drain voltage $V_{DS}$, for various values of voltage between gate and source (gate-source voltage) $V_{GS}$. As can be seen from the graph drain current has a saturation region and an unsaturation region.

In the saturation region, the drain current $I_D$ can be expressed as

$$I_D = I_{DSS} \left( 1 - \frac{V_{GS}}{V_P} \right)^2 \qquad (1)$$

where $V_{GS}$ is gate-source voltage, $I_{DSS}$ is saturation drain current when $V_{GS}=0$ and $V_P$ is the pinch off voltage.

In the unsaturation region, the drain current $I_D$ is given by

$$I_D = \frac{1}{R_{min}} \left\{ V_{DS} - \frac{2}{3} \cdot \frac{1}{\sqrt{V_P}} [(V_{DS}+V_{GS})^{3/2} - V_{GS}^{3/2}] \right\} \qquad (2)$$

where $V_{DS}$ is source-drain voltage and $R_{min}$ is resistance between source and drain when $V_{DS}=0$ and $V_{GS}=0$.

These equations are well known. More detail is given in, for example, Physics of Semi-conductor Devices: John Wiley & Sons, Inc. N.Y. 1969.

In the circuit of Figure 1, if transistor $J_1$ is operated in a saturation region, in accordance with equation (1), and its drain current is fixed by constant current source $I_C$, its gate source voltage $V_{GS1}$ is also fixed. Thus, in the circuit of Figure 1 when the voltage of the gate $J_1$ follows changes in the source voltage of transistor $J_0$, the bottom terminal (the negative terminal) of control voltage source $E_K$ also follows those changes. Consequently, the top terminal of control voltage source $E_K$ follows the changes in the source voltage of transistor $J_0$, which means that the gate of the transistor $J_0$ follows those changes, thereby to maintain $V_{GS0}$ constant.

$R_{ON}$, the resistance between source and drain of transistor $J_0$ when it is in an ON (conductive) unsaturated state, is given by

2

$$R_{ON} = \frac{V_{DS0}}{I_{D0}} = R_{min} \frac{V_{DS0}}{V_{DS0} - \frac{2}{3} \cdot \frac{1}{\sqrt{V_P}}[(V_{DS0}+V_{GS0})^{3/2} - V_{GS0}^{3/2}]}$$

where, $V_{DS0}$, $V_{GS0}$ and $I_{D0}$ are absolute values of source-drain voltage, gate-source voltage, and drain current of transistor $J_0$.

It should be noted that equation (2) is expressed in terms of absolute values. For a p-channel FET, such as $J_0$, when $V_{GS}$ is positively biased and $V_{DS}$ is negatively biased, it is necessary to replace $V_{DS0}$ in the above equation by $-V_{DS0}$. Therefore

$$R_{ON} = R_{min} \frac{V_{DS0}}{V_{DS0} + \frac{2}{3} \cdot \frac{1}{\sqrt{V_P}}[(V_{GS0}-V_{DS0})^{3/2} - V_{GS0}^{3/2}]} \qquad (3)$$

in which $V_{DS0} < 0$.

On the other hand, when $V_{DS0} > 0$, i.e. when the drain voltage is greater than the source voltage, the drain current $I_{D0}$ of $J_0$, a p-channel FET, is controlled by $V_{GD0}$, the gate-drain voltage of $J_0$ (contrary to the above-mentioned case, in which $V_{GS0}$ is controlling) and of course the direction of $I_{D0}$ is reversed. Thus

$$R_{ON} = R_{min} \frac{V_{DS0}}{V_{DS0} - \frac{2}{3} \cdot \frac{1}{\sqrt{V_P}}[(V_{DS0}+V_{GD0})^{3/2} - V_{GD0}^{3/2}]} \qquad (4)$$

As noted above, $V_{GS0}$ is constant. So $V_{GD0} = V_{GS0} - V_{DS0}$.
From this and from equation (4), $R_{ON}$ is given by

$$R_{ON} = R_{min} \frac{V_{DS0}}{V_{DS0} + \frac{2}{3} \cdot \frac{1}{\sqrt{V_P}}[(V_{GS0}-V_{DS0})^{3/2} - V_{GS0}^{3/2}]} \qquad (5)$$

This is the same equation as (3).

Thus, equation (3) can be applied for all values of $V_{DS0}$ regardless of the sign of $V_{DS0}$.

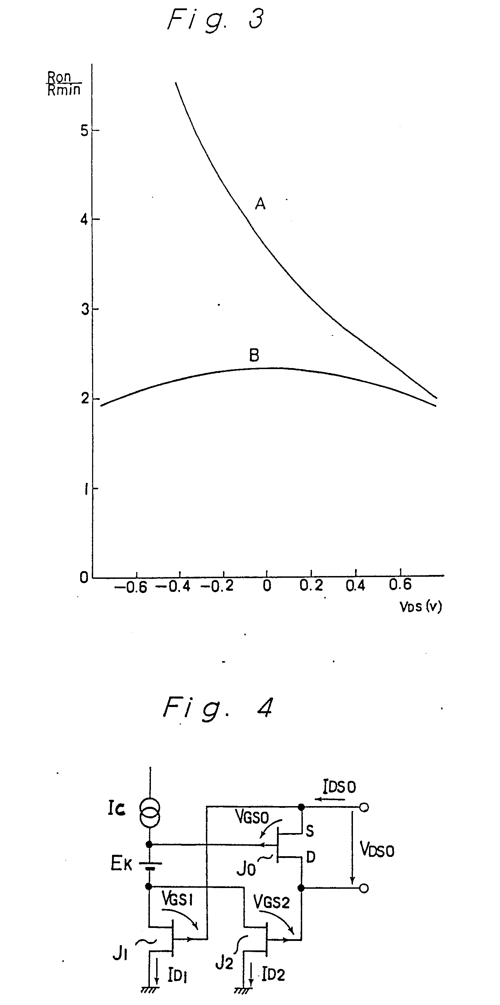

In the graph of Figure 3, curve A illustrates the relationship of equation (5) [and equation (3)], under conditions that $|V_p| > |V_{GS0}|$, and $|V_p| > |V_{GD0}|$. As can be seen in the graph, in the region where $V_{DS0} < 0$, $R_{ON}$ increases, whilst in the region where $V_{DS0} > 0$, $R_{ON}$ decreases as compared to its value at $V_{DS0} = 0$, giving an asymmetric characteristic for $R_{ON}$ as seen in the graph of Figure 3.

For the graph of Figure 3 values were calculated from equation (5) with $V_p = 1.5$ volt and $V_{GS0} = 0.8$ volt.

The asymmetric $R_{ON}$ characteristic seen in the graph gives rise to asymmetric current and voltage characteristics for signals passing through the FET, which causes distortion as mentioned above.

IEEE Journal of Solid-State Circuits, Vol. SC-14, No. 6, December 1979, "Temperature Compensated Quad Analog Switch", pages 944—952, discloses a switch using bipolar and junction field effect transistors for switching on analog signal. Particular attention is paid to the stability of ON-resistance with variations in temperature.

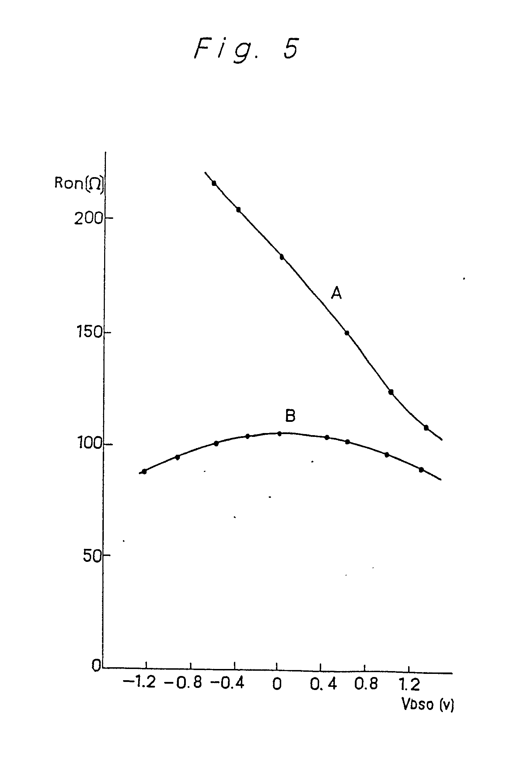

Figure 8 of the above document depicts a simplified schematic of the switch. The switch has a first FET ($J_{11}$), having source and drain, between which the analog signal passes when the FET is in a conductive state, such passage being blocked when the FET is in a non-conductive state; voltage control circuitry (LOGIC INPUT, $Q_1$, $Q_5$, $Q_2$, $Q_4$, $Q_7$, etc.) operable to control the gate voltage of the first FET and to control the conductance of the first FET; a unity gain buffer, including a second FET ($J_{10}$, see also Figure 5) the gate of which is connected to the source of the first FET, which is said to maintain the gate-source voltage of the switch device (the first FET) constant with variations in its source voltage, for keeping the ON-resistance of the switch unchanged when the analog input voltage varies. Current supply to the second FET is from a further FET ($J_9$—Figure 5) and associated components which appear to provide a constant current through the second FET ($J_{10}$).

According to the present invention there is provided a gate circuit, employing field effect transistors for switching an analog signal, comprising:

a first field effect transistor (FET) having first and second terminals, of which, at any one time, one acts as source and the other as drain, and having a gate, the analog signal passing between the first and second

0 108 603

terminals of the first FET when that FET is in a conductive state but such passage being blocked when the first FET is in a non-conductive state;

a control voltage source operable to control the gate voltage of the first FET and to control the conductance of the first FET between the first and second terminals;

a second FET arranged for detecting the voltage of a first terminal of the first FET and operable to keep variation of the voltage between the gate and the first terminal of the first FET small when the first FET is in a conductive state; and

a constant current source arranged for supplying current to the second FET; characterised in that a third FET is arranged for detecting the voltage of the second terminal of the first FET and is operable to keep variation of the voltage between the gate and the second terminal of the first FET small when the first FET is in a conductive state; and in that

the constant current source is arranged for supplying constant current to the second and third FETs.

An embodiment of the present invention can provide a gate circuit (a switching circuit) from field effect transistors, in which distortion is reduced.

In a gate circuit embodying the present invention the distortion of signals passing through the circuit is reduced by effecting an improvement in relation to the unsymmetrical characteristics of internal resistance when the circuit is in an on state.

An embodiment of the present invention can provide a gate circuit (a switching circuit) of field effect transistors whose ON state source-drain internal resistance ($R_{ON}$) is small and is symmetrical with respect to source-drain voltage ($V_{DS}$), thus reducing second order distortion.

Briefly, in an embodiment of the present invention, source side and drain side voltages of a switching transistor are detected and appropriately fed back to the gate of the transistor. By such feedback the resistance of the switching transistor becomes small and symmetric with respect to the zero point of source-drain voltage.

Reference is made, by way of example, to the accompanying drawings, in which:—

Figure 1 is a schematic circuit diagram of main parts of a previous switching circuit using field effect transistors;

Figure 2 is a graph illustrating static characteristics of a field effect transistor,

Figure 3 is a graph illustrating calculated on-state resistance characteristics of the previous switching circuit (curve A) and a circuit embodying the present invention (curve B),

Figure 4 is a schematic circuit diagram of main parts of a switching circuit embodying the present invention;

Figure 5 is a graph illustrating measured on-state resistance characteristics of a previous switching circuit (curve A) and a circuit embodying the present invention (curve B), and

Figure 6 is a circuit diagram of an embodiment of the present invention.

The switching circuit of Figure 4, embodying the present invention, is provided with an additional field effect transistor (FET) $J_2$ as compared with Figure 1. Transistor $J_2$ detects the drain voltage of FET $J_0$ and corrects the gate voltage of $J_0$. In this circuit, the field effect transistor $J_0$ should have a symmetrical source-drain current vs source-drain voltage characteristic, when the polarity of the voltage is reversed (that is, when the source and drain electrodes are connected one in place of the other). But is is well known that conventional FETs usually have such symmetrical characteristics.

In the circuit of Figure 4, when the absolute value of $V_{DS0}$, the source-drain voltage of $J_0$, is high, the gate voltage of field effect transistor $J_0$ is controlled by that one of FETs $J_1$ or $J_2$ whose gate is connected to the lower voltage side of $J_0$, because the source and drain electrodes of $J_1$ and $J_2$ are commonly connected to the voltage source $E_K$ and to ground respectively. Thus, the transistor ($J_1$ or $J_2$) whose gate is connected to the higher voltage side will be pinched off, and the transistor ($J_2$ or $J_1$) whose gate is connected to the lower voltage side controls the gate of $J_0$.

In a case in which the absolute value of $V_{DS0}$ is not so high, the situation is almost the same; $J_0$ is mainly controlled by that one of $J_1$ or $J_2$ whose gate voltage is connected to the lower voltage but both $J_1$ and $J_2$ play a part in the control.

Namely, when $V_{DS0}<0$ (which means that the voltage of drain D of $J_0$ is lower than that of source S of $J_0$) and the absolute value of $V_{DS0}$ is sufficiently high as mentioned above, the FET $J_0$ is controlled by $J_2$. In this case, $J_1$ can be neglected because it is pinched off. $J_2$ is conductive and the current running through $J_2$ is constant current $I_C$. So, $V_{GS2}$ is constant, independent to its gate voltage. Thus, the gate voltage of $J_0$ ($V_{GS0}$) becomes lower than at $V_{DS0}=0$, because drain voltage is lower than source voltage. Further $R_{ON}$, the resistance between source and drain of $J_0$, decreases below its value at $V_{DS0}=0$. This will be understood from the graph of Figure 2, showing FET characteristics. As $V_{GS0}$ decreases, the applicable $V_{DS}$ versus $I_D$ curve shifts towards that applicable for $V_{GS0}=0$, and the gradient of the applicable curve in the unsaturation region becomes steeper. Thus, the differential conductance increases, and $R_{ON}$ (the inverse of conductance) decreases.

On the other hand when $V_{DS0}>0$ (that is, the voltage of drain D of $J_0$ is higher than the voltage of its source S) and the absolute value of $V_{DS0}$ is sufficiently high as mentioned above, the FET $J_1$ controls $J_0$. In this case, by reason of the aforementioned symmetrical characteristics of FET $J_0$, the situation is same except that the source and drain of $J_0$ are effectively interchanged. Thus, the resistance $R_0$ again decreases.

As indicated above, when the absolute value of $V_{DS0}$ is not so high both $J_1$ and $J_2$ play a part. The

4

performance of the circuit of Figure 4 can be analysed with the assistance of some equations. For the sake of simplicity, it is assumed that $R_{min}$, $I_{DSS}$ and $V_p$ of $J_1$ are equal to those of $J_2$. Since the circuit is operated by a constant current source $I_c$, and $I_c$ is the sum of the drains current $I_{D1}$ and $I_{D2}$ of $J_1$ and $J_2$, it is obtained from equation (1) that

$$I_{DSS}\left(1-\frac{V_{GS1}}{V_P}\right)^2+I_{DSS}\left(1-\frac{V_{GS2}}{V_P}\right)^2=I_c \tag{6}$$

if both $J_1$ and $J_2$ are operating in their saturation regions, and the following relationship holds.

$$V_{DS0}=V_{GS2}-V_{GS1}. \tag{7}$$

$R_{ON}$, the on-state resistance (unsaturated) between source and drain of FET $J_0$, is given by

$$R_{ON}=V_{DS0}/I_{D0}$$

and, using equation (3) and (5)

$$R_{ON}=R_{min}\frac{V_{DS0}}{V_{DS0}+\dfrac{2}{3}\dfrac{1}{\sqrt{V_P}}[(V_{GS0}-V_{DS0})^{3/2}-V_{GS0}^{3/2}]} \tag{8}$$

Substituting (7) into (6) and eliminating $V_{GS2}$, the following is obtained

$$V_{GS1}=V_P-\frac{V_{DS0}}{2}\pm\sqrt{\frac{1}{2}V_P^2\frac{I_c}{I_{DSS}}-\frac{1}{4}V_{DS0}^2}$$

In this equation the $-$ sign of $\pm$ should be chosen. The reason for this is that for $V_{DS0}=0$, $V_{GS}$ should be larger than $V_p$. Therefore

$$V_{GS1}=V_P-\frac{V_{DS0}}{2}-\sqrt{\frac{1}{2}V_P^2\frac{I_c}{I_{DSS}}-\frac{1}{4}V_{DS0}^2} \tag{9}$$

Since

$$V_{GS0}=E_K-V_{GS1} \tag{10}$$

substituting (10) and (9) into equation (8), $R_{ON}$ can be expressed as a function of $V_{DS0}$ as,

$$R_{ON}=R_{min}\cdot V_{DS0}/\{V_{DS0}+\frac{2}{3}\frac{1}{\sqrt{V_P}}[(E_K-V_P-\frac{V_{DS0}}{2}+\sqrt{\frac{1}{2}V_P^2\frac{I_c}{I_{DSS}}-\frac{1}{4}V^2_{DS0}})^{3/2}$$

$$-(E_K-V_P+\frac{V_{DS0}}{2}+\sqrt{\frac{1}{2}V_P^2\frac{I_c}{I_{DSS}}-\frac{1}{4}V^2_{DS0}})^{3/2}]\} \tag{11}$$

In the graph of Figure 3, the $R_{ON}$ characteristic for $J_0$ in the circuit of Figure 4 is shown by curve B. For deriving the curve B it was taken that $V_p=1.5$ volt, $V_{GS0}=0.8$ volt $(V_{DS0}=0)$, $I_c/I_{DSS}=0.5$ (namely, $V_{GS1}=V_{GS2}=0.44$ volts, $V_{DS0}=0$), $E_K=1.24$ volt. As can be seen in the graph $R_{ON}$ decreases on both sides of $V_{DS}=0$ regardless of source-drain voltage polarity.

The graph of Figure 5 illustrates an example of measured values of $R_{ON}/R_{min}$ as a function of amplitude $(V_{DS})$ corresponding to calculated values of Figure 3. In the graph of Figure 5 curve A relates to measured values for a previous circuit, and curve B relates to measured values for a circuit embodying the present invention. As can be seen, the embodiment of present invention offers a significant improvement. Further it will be seen that there is good agreement between measured and calculated characteristics. $R_{ON}$ in the embodiment of the present invention is much smaller than in the previous circuit. Moreover, curve B has a gentle slope as compared to curve A, and it is symmetric on both sides of $V_{DS}=0$. Thus, distortion resulting from variation in internal resistance of the switching circuit is reduced. In particular second order distortion is reduced to a great extent.

The description given above in relation to the present invention has been concerned with a circuit using p-channel type FETs. However it will be clear to those skilled in the art that the invention can also be applied to circuits using n-channel type FETs by appropriately reversing the polarities of voltages applied to parts of the circuit. It will be also clear that any kind of field effect transistor, such as MOS (metal oxide semiconductor) type or junction type FETs, can be applied in embodiments of the present invention. For the sake of simplicity, the description hereinafter will also be given with respect to p-channel FETs.

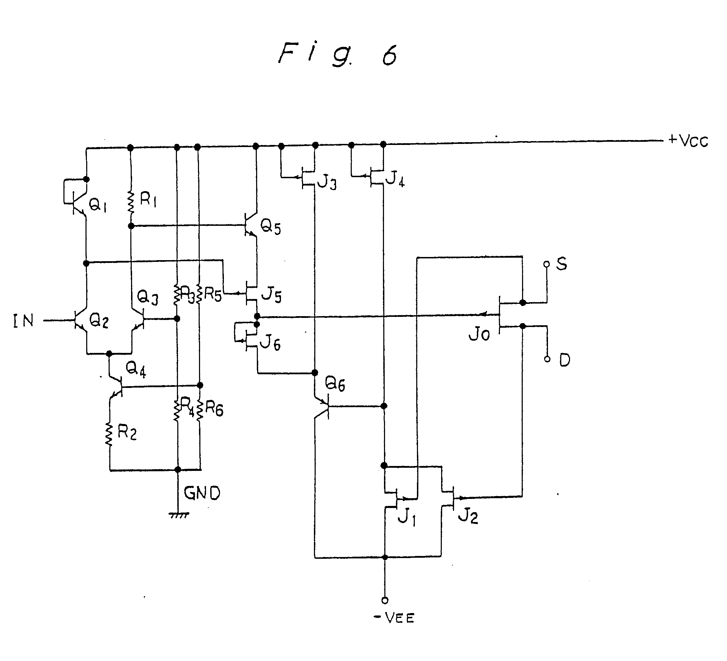

Figure 6 is a circuit diagram of an example of a switching circuit embodying the present invention. In Figure 6, $J_0$ to $J_2$ designate field effect transistors which form a switching circuit as shown in Figure 4. $J_3$ to $J_6$ are FETs. $Q_1$ to $Q_5$ and $Q_6$ are opposite type transistors (npn and pnp transistors) respectively, and $R_1$ to $R_6$ are resistors.

Transistors $J_5$, $J_6$ and $Q_5$, $Q_6$ work to generate the control voltage corresponding to $E_K$ in Figure 4.

Each of $J_3$ and $J_4$ has its gate and source electrodes shorted together, so each operates in a saturation region and works as a constant current source. $J_3$ works as a current source for $E_K$ and $J_4$ corresponds to the constant current source $I_C$ in Figure 4.

Resistors $R_3$ and $R_4$ divide the source or supply voltage $V_{CC}$ to supply base bias voltage to transistor $Q_3$. Similarly, $R_5$ and $R_6$ supply the base bias voltage of $Q_4$ by dividing $V_{CC}$. The other transistors and resistors constitute a circuit to control $E_K$.

An analog signal applied between the terminals S and D of $J_0$ is gated (switched) on and off by a control signal applied to input terminal IN. The input control signal may be any type of on-off signal, such as the output signal of a logic circuit, for example.

Operation of the circuit of Figure 6 is as follows.

When the switching signal applied to the terminal IN is low level, the emitter coupled transistor $Q_2$ is off, $Q_3$ is on, and current runs through the resistor $R_1$. The circuit constants are selected to keep the voltage drop across the resistor $R_1$ higher than the pinch off voltage of $J_5$. Thus, $J_5$ is cut off and current does not flow through $J_6$. Moreover, the gate and source of $J_6$ are shorted to one another and the voltage drop in the transistor $J_6$ is almost zero. In this case the voltage ($E_K$) which controls $J_0$ falls to the base-emitter voltage $V_{BE}$ of $Q_6$ (approximately 0.7 V), and the switching transistor $J_0$ becomes conductive, thus the analog signal applied to the terminals S and D is passed (the gate is opened).

When the control signal applied to the terminal IN is high level, on the other hand, transistor $Q_2$ is on, $Q_3$ is off and the voltage drop across resistor $R_1$ becomes negligible. The transistors $Q_5$ and $J_5$ become conductive. Transistor $Q_1$, which is a npn transistor similar to $Q_5$, has its base connected to its collector, and functions as a diode to provide same voltage drop of $Q_1$ (the same drop as $Q_5$) when $J_5$ is on (conductive). Thus, the gate-source voltage of $J_5$ is almost 0, and $J_5$ becomes conductive. Transistors $J_5$ and $J_6$ are selected beforehand so that $I_{DSS}$ the saturation current of $J_5$ is much larger than (for example about 10 times as large as) that of $J_6$. Therefore, in this case, $J_5$ is operated in an unsaturated region, and $J_6$ is operated in a saturated region. The drain-source voltages $V_{DS}$ of $J_5$ and $J_6$ become respectively $V_{DS5}<V_p$ and $V_{DS6}>V_p$. Therefore, the gate voltage of $J_0$ goes up almost to the voltage of $V_{CC}$, and it does not depend on the voltage of $Q_6$. Thus, the gate transistor $J_0$ is pinched off, and analog signal applied between the terminals S and D is choked off (the gate is closed). Selection of saturation current of $J_5$ and $J_6$ is not critical; it is sufficient if, for example, the saturation current of $J_6$ is less than a quarter that of $J_5$.

In the above manner the switching circuit for analog signals is operated. The circuit shown in Figure 6 is an example of an embodiment of the present invention. Many other circuits may be devised in accordance with the present invention.

It will be seen, by comparing the circuit of Figure 6 with the circuit of Figure 4, that in Figure 6 the drain electrodes of $J_1$ and $J_2$ are connected to a negative voltage $-V_{EE}$. Thereby, the circuit of Figure 6 is operable for both positive and negative signed analog signals. The ground (earth) voltage is used as a reference voltage of a logic circuit.

As described above, a gate circuit embodying the present invention detects the voltage not only of the source but also of the drain side of a switching FET, and feeds back the detected voltages to correct the gate voltage. Thus, variation of on-state resistance of the FET is decreased and moreover, the on-state resistance varies symmetrically with respect to positive and negative voltages, so that second order distortion is reduced to a great extent.

As has been stated above, the invention has been described mainly in the context of a p-channel switching FET, but it will be clear that embodiments of the invention can be applied to n-channel switching FETs, merely by appropriate reversal of the polarity of applied voltages. They can also be applied to MOS type, junction type, and any other kind of field effect transistors.

## Claims

1. A gate circuit, employing field effect transistors for switching an analog signal, comprising:
a first field effect transistor (FET) ($J_0$) having first and second terminals, of which, at any one time, one acts as source and the other as drain, and having a gate, the analog signal passing between the first and second terminals of the first FET when that FET is in a conductive state but such passage being blocked when the first FET is in a non-conductive state;

a control voltage source ($E_K$; $J_5$, $J_6$, $Q_5$, $Q_6$) operable to control the gate voltage of the first FET and to control the conductance of the first FET between the first and second terminals;

a second FET ($J_1$) arranged for detecting the voltage of a first terminal of the first FET and operable to keep variation of the voltage between the gate and the first terminal of the first FET small when the first FET is in a conductive state; and

a constant current source ($I_C$, $J_4$) arranged for supplying current to the second FET; characterised in that

a third FET ($J_5$) is arranged for detecting the voltage of the second terminal of the first FET and is operable to keep variation of the voltage between the gate and the second terminal of the first FET small when the first FET is in a conductive state; and in that

the constant current source is arranged for supplying constant current to the second and third FETs.

2. A circuit as claimed in claim 1, in which the control voltage source ($E_K$; $J_5$, $J_6$, $Q_5$, $Q_6$) supplies a control voltage between the gate of the first FET ($J_0$) and the sources of the second and third FETs ($J_1$, $J_2$), the first terminal of the first FET is operatively connected to one analog signal terminal (S) of the circuit and the gate of the second FET, the second terminal of the first FET is operatively connected to another analog signal terminal (D) of the circuit and the gate of the third FET, the gate of the first FET is operatively connected to the constant current source ($I_C$, $J_4$) and to one side of the control voltage source, the source, of the second and third FETs are operatively connected to the other side of the control voltage source, and the drains of the second and third FETs are operatively connected to ground.

3. A circuit as claimed in claim 2, further comprising a bias voltage source ($-V_{EE}$) supplying a constant voltage opposite to a supply voltage ($V_{CC}$), the drains of the second and third FETs ($J_1$, $J_2$) being operatively grounded through the bias voltage source.

4. A circuit as claimed in claim 1, 2 or 3, wherein the first FET ($J_0$) has a symmetrical characteristic of drain current against source-drain voltage.

5. A circuit as claimed in any preceding claim, wherein the FETs ($J_0$ to $J_2$) are p-channel FETs and the control voltage source comprises:

a fourth p-channel FET ($J_5$), the source of which is connected to receive a supply voltage ($V_{CC}$) via npn transistor ($Q_5$), the gate of which is connected to receive a control signal, and the drain of which is connected to the gate of the first FET ($J_0$);

a fifth p-channel FET ($J_6$), the saturation drain current of which is less than a quarter that of the fourth FET, connected in series with respect to the drain electrode of the fourth FET, the gate of the fifth p-channel FET. being connected to its source, and the drain of the fifth p-channel FET being connected to a constant current source ($J_3$); and

a pnp transistor ($Q_6$), the emitter of which is connected to the drain of the fifth FET, the base of which is connected to the source of the second FET, and the collector of which is connected to the drain of the second FET,

the base of the npn transistor ($Q_5$) being arranged to receive a control signal of an opposite phase to that supplied to the gate of the fourth FET.

6. A circuit as claimed in claim 5, in which the p-channel FETs ($J_0$ to $J_2$, $J_5$, $J_6$), the npn transistor ($Q_5$) and the pnp transistor ($Q_6$) are replaced respectively by n-channel FETs, a pnp transistor and a npn transistor, and polarity of supply voltage ($V_{CC}$) and current are reversed.

**Patentansprüche**

1. Torschaltung, unter Verwendung eines Feldeffekttransistors zum Schalten eines Analogsignales, mit:

einem ersten Feldeffekttransistor (FET) ($J_0$), der erste und zweite Anschlüsse hat, von denen, zu irgendeiner Zeit, einer als Source und der andere als Drain wirkt, und der ein Gate hat, und bei welchem das Analogsignal zwischen dem ersten und dem zweiten Anschluß des ersten FET passiert, wenn der FET in einem leitenden Zustand ist, solch eine Passage jedoch blockiert ist, wenn der erste FET in einem nichtleitenden Zustand ist;

einer Steuerspannungsquelle ($E_K$; $J_5$, $J_6$, $Q_5$, $Q_6$), die betreibbar ist, um die Gatespannung des ersten FET zu steuern, und um die Leitfähigkeit des ersten FET zwischen dem ersten und dem zweiten Anschluß zu steuern;

einem zweiten FET ($J_1$), der angeordnet ist, um die Spannung des ersten Anschlusses des ersten FET zu detektieren, und betreibbar ist, um die Variation der Spannung zwischen dem Gate und dem ersten Anschluß des ersten FET klein zu halten, wenn der erste FET in einem leitenden Zustand ist;

einer Konstantstromquelle ($I_C$, $J_4$), die angeordnet ist, um dem zweiten FET einen Strom zuzuführen; dadurch gekennzeichnet, daß

ein dritter FET ($J_5$) angeordnet ist, um die Spannung des zweiten Anschlusses des ersten FET zu detektieren, und betreibbar ist, um die Variation der Spannung zwischen dem Gate und dem zweiten Anschluß des ersten FET kleinzuhalten, wenn der erste FET in einem leitenden Zustand ist; und daß

die Konstantstromquelle angeordnet ist, um dem zweiten und dem dritten FET einen konstanten Strom zu liefern.

2. Schaltung nach Anspruch 1, bei der die Steuerspannungsquelle ($E_K$; $J_5$, $J_6$, $Q_5$, $Q_6$) eine

Steuerspannung zwischen dem Gate des ersten FET ($J_0$) und den Sourcen des zweiten und des dritten FET ($J_1$, $J_2$) liefert, wobei der erste Anschluß des ersten FET wirkungsmäßig mit einem Analogsignalanschluß (S) der Schaltung und dem Gate des zweiten FET verbunden ist, der zweite Anschluß des ersten FET wirkungsmäßig mit einem anderen Analogsignalanschluß (D) der Schaltung und dem Gate des dritten FET verbunden ist, das Gate des ersten FET wirkungsmäßig mit der Konstantstromquelle ($I_C$, $J_4$) und einer Seite der Steuerspannungsquelle verbunden ist, die Source des zweiten und des dritten FET wirkungsmäßig mit der anderen Seite der Steuerspannungsquelle verbunden sind und die Drains des zweiten und dritten FET wirkungsmäßig mit Erde verbunden sind.

3. Schaltung nach Anspruch 2, ferner mit einer Vorspannungsquelle ($-V_{EE}$), die eine Konstantspannung zuführt, welche entgegengesetzt zu einer Versorgungsspannung ($V_{CC}$) ist, bei welcher die Drains des zweiten und des dritten FET ($J_1$, $J_2$) wirkungsmäßig über die Vorspannungsquelle geerdet sind.

4. Schaltung nach Anspruch 1, 2 oder 3, bei der das erste FET ($J_0$) eine symmetrische Charakteristik des Drainstroms gegen die Source-Drain-Spannung hat.

5. Schaltung nach einem der vorhergehenden Ansprüche, bei der die FETs ($J_0$ bis $J_2$) p-Kanal-FETs sind und die Steuerspannungsquelle umfaßt:

einen vierten p-Kanal-FET ($J_5$) dessen Source angeschlossen ist, um eine Versorgungsspannung ($V_{CC}$) über einen npn-Transistor ($Q_5$) zu empfangen, dessen Gate angeschlossen ist, um ein Steuersignal zu empfangen, und dessen Drain mit dem Gate des ersten FET ($J_0$) verbunden ist,

einen fünften p-Kanal-FET ($J_6$), dessen Sättigungsdrainstrom kleiner als ein Viertel desjenigen des vierten FET ist, der in Bezug auf die Drainelektrode des vierten FET in Reihe angeschlossen ist, wobei das Gate des fünften p-Kanal-FET mit seiner Source verbunden ist und das Drain des fünften p-Kanal-FET mit einer Konstantstromquelle ($J_3$) verbunden ist; und

einen pnp-Transistor ($Q_6$) dessen Emitter mit dem Drain des fünften FET verbunden ist, dessen Basis mit der Source des zweiten FET verbunden ist, und dessen Kollektor mit dem Drain des zweiten FET verbunden ist,

wobei die Basis des npn-Transistors ($Q_5$) angeordnet ist, um ein Steuersignal von einer Phase zu empfangen, die entgegengesetzt zu derjenigen ist, welche dem Gate des vierten FET zugeführt wird.

6. Schaltung nach Anspruch 5, bei der die p-Kanal-FETs ($J_0$ bis $J_2$, $J_5$, $J_6$), der npn-Transistor ($Q_5$) und der pnp-Transistor ($Q_6$) durch entsprechende n-Kanal-FETs, einen pnp-Transistor und einen npn-Transistor, ersetzt sind und die Polarität der Versorgungsspannung ($V_{CC}$) und der Strom umgekehrt sind.

## Revendications

1. Circuit de porte utilisant des transistors à effet de champ pour commuter un signal analogique, comportant:

un premier transistor à effet de champ ou FET ($J_0$) ayant une première et une seconde borne dont, à un instant donné, l'une fonctionne comme une source et l'autre comme un drain, et avec une grille, le signal analogique passant entre la première et la seconde borne du premier FET quand ce dernier est à l'état conducteur, mais ce passage étant bloqué quand le premier FET est à l'état non conducteur;

une source de tension de commande ($E_K$; $J_5$, $J_6$, $Q_5$, $Q_6$) ayant pour fonction de commander la tension de grille du premier FET et d'en commander la conductance entre la première et la seconde borne;

un second FET ($J_1$) agencé pour détecter la tension d'une première borne du premier FET et ayant pour fonction de maintenir réduite la variation de la tension entre la grille et la première borne du premier FET quand ce premier est à l'état conducteur; et

une source de courant constant ($I_C$, $J_4$) agencée pour fournir un courant au second FET; caractérisé en ce que

un troisième FET ($J_5$) est agencé pour détecter la tension de la seconde borne du premier FET et a pour fonction de maintenir réduite la variation de la tension entre la grille et la seconde borne du premier FET quand ce dernier est à l'état conducteur;

et en ce que la source de courant constant est agencée pour fournir un courant constant au second et au troisième FET.

2. Circuit selon la revendication 1, dans lequel la source de tension de commande ($E_K$, $J_5$, $J_6$, $Q_5$, $Q_6$) fournit une tension de commande entre la grille du premier FET ($J_0$) et les sources du second et du troisième FET ($J_1$, $J_2$), la première borne du premier FET étant connectée en fonctionnement à une borne de signal analogique (S) du circuit et à la grille du second FET; la seconde borne du premier FET étant connectée en fonctionnement à une autre borne de signal analogique (D) du circuit et à la grille du troisième FET, la grille du premier FET étant connectée en fonctionnement à la source de courant constant ($I_C$, $J_4$) et à un côté de la source de tension de commande, la source du second et du troisième FET étant connectée en fonctionnement à l'autre côté de la source de tension de commande et les drains du second et du troisième FET étant connectés en fonctionnement à la masse.

3. Circuit selon la revendication 2, comportant en outre une source de tension de polarisation ($-V_{EE}$) fournissant une tension constante opposée à la tension d'alimentation ($V_{CC}$), les drains du second et du troisième FET ($J_1$, $J_2$) étant à la masse par la source de tension d'alimentation.

4. Circuit selon la revendication 1, 2 ou 3, dans lequel le premier FET ($J_0$) a une caractéristique symétrique de courant de drain en fonction de la tension source-drain.

**0 108 603**

5. Circuit selon l'une quelconque des revendications précédentes, dans lequel les FET ($J_0$ à $J_2$) sont des FET à canal P et la source de tension de commande comporte:

un quatrième FET ($J_5$) à canal P dont la source est connectée pour recevoir une tension d'alimentation ($V_{CC}$) par l'intermédiaire d'un transistor NPN ($Q_5$) dont la grille est connectée pour recevoir un signal de commande et dont le drain est connecté à la grille du premier FET ($J_0$);

un cinquième FET ($J_6$) à canal P dont le courant de drain à saturation est inférieure au quart de celui du quatrième FET, connecté en série avec l'électrode de drain du quatrième FET, la grille du cinquième FET à canal P étant connectée à sa source et le drain du cinquième FET à canal P étant connectée à une source de courant constant ($J_3$); et

un transistor PNP ($Q_6$) dont l'émetteur est connecté au drain du cinquième FET, dont la base est connectée à la source du second FET et dont le collecteur est connecté au drain du second FET,

la base du transistor NPN ($Q_5$) étant agencée pour recevoir un signal de commande d'une phase opposée à celle appliquée à la grille du quatrième FET.

6. Circuit selon la revendication 5, dans lequel les FET à canal P ($J_0$ à $J_2$, $J_3$, $J_6$), le transistor NPN ($Q_5$) et le transistor PNP ($Q_6$) sont remplacés respectivement par des FET à canal N, un transistor PNP et un transistor NPN, la polarité de la tension d'alimentation ($V_{CC}$) et le courant étant inversés.

9

# Fig. 1

# Fig. 2

Fig. 3

Fig. 4

2

# Fig. 5

## F i g. 6